# EUROPÄISCHE PATENTANMELDUNG

(11) **EP 4 087 379 A1**
(43) Veröffentlichungstag der Anmeldung: **09.11.2022**
(21) Anmeldenummer: 22174745.4
(22) Anmeldetag: 23.09.2020
(51) Int. Cl.: H05K 7/20

(54) **SCHALTSCHRANKANORDNUNG MIT MINDESTENS EINEM IT-RACK ODER SCHALTSCHRANKGEHÄUSE UND MIT MINDESTENS EINEM KÜHLGERÄT SOWIE EIN ENTSPRECHENDES VERFAHREN**

(30) Priorität: 23.09.2019 DE 102019125512; 23.09.2019 DE 102019125534; 28.02.2020 DE 102020105359; 13.08.2020 WO PCT/DE2020/100704
(62) Teilanmeldung aus: 20792282.4
(71) Anmelder: Rittal GmbH & Co. KG, 35745 Herborn (DE)
(72) Erfinder: HIMMELHUBER, FRANK, 92245 Kümmersbruck (DE); MATTHIES, STEPHAN HELMUT, 57076 Siegen (DE); MEYER, ANDREAS, 35112 Fronhausen (DE)
(74) Vertreter: Angerhausen, Christoph

(57) **Zusammenfassung**

Die Erfindung betrifft eine Schaltschrankanordnung mit mindestens einem IT-Rack oder Schaltschrankgehäuse (1), durch das Luft zur Kühlung von in dem IT-Rack oder Schaltschrankgehäuse (1) aufgenommenen Komponenten (4) hindurchgeleitet ist, wobei von der Luft ein Luft-Flüssigkeit-Wärmeübertrager (18) eines Kühlkreislaufes beaufschlagt und eine durch den Luft-Flüssigkeit-Wärmeübertrager (18) geleitete Flüssigkeit mindestens einer der Komponenten (4) für die Wärmeübertragung von der Komponente (4) auf die Flüssigkeit zugeleitet und von der Komponente (4) zurück in den Luft-Flüssigkeit-Wärmeübertrager (18) abgeleitet ist. Es wird weiterhin ein entsprechendes Verfahren beschrieben.

## Beschreibung

Die Erfindung geht aus von einer Schaltschrankanordnung mit mindestens einem IT-Rack oder Schaltschrankgehäuse und mit mindestens einem Kühlgerät, das einen Luft-Flüssigkeit-Wärmeübertrager zur Kühlung von in dem IT-Rack oder Schaltschrankgehäuse aufgenommenen Komponenten mit gekühlter Luft aufweist, wobei der Luft-Flüssigkeit-Wärmeübertrager einen ersten Vorlauf für gekühlte Flüssigkeit und einen ersten Rücklauf für erwärmte Flüssigkeit aufweist. Eine derartige Schaltschrankanordnung ist beispielsweise aus der DE 10 2015 101022 B3 bekannt.

Die in einem Schaltschrankgehäuse bzw. in einem IT-Rack angeordneten Komponenten weisen in der Regel eine starke bauartabhängige Verlustleistung sowie einen entsprechend stark von Komponente zu Komponente variierenden Kühlleistungsbedarf auf. Andererseits wird die Kühlleistung in gängigen Schaltschrankanordnungen komponentenunabhängig mit einer Kühlluft derselben Temperatur bereitgestellt, welche die kühlungsbedürftigen Komponenten umströmt. Folglich werden die Kühllufttemperatur und deren Strömungsgeschwindigkeit stets dahingehend eingestellt, dass für die Komponenten mit dem höchsten Kühlleistungsbedarf eine ausreichende Kühlleistung bereitgestellt werden kann. Im Umkehrschluss hat dies jedoch zur Folge, dass weniger kühlungsbedürftige Komponenten übermäßig gekühlt werden, wodurch das Gesamtkühlungskonzept der Schaltschrankanordnung energieineffizient ist.

Es ist daher die Aufgabe der Erfindung, eine Schaltschrankanordnung der eingangs beschriebenen Art derart weiter zu entwickeln, dass eine energieeffiziente Kühlung von Komponenten unterschiedlichen Kühlleistungsbedarfs derselben Schaltschrankanordnung möglich ist.

Diese Aufgabe wird durch eine Schaltschrankanordnung mit den Merkmalen des Anspruchs 1 gelöst. Die abhängigen Ansprüche betreffen jeweils vorteilhafte Ausführungsformen der Erfindung.

Aufgrund der im Vergleich zu Luft besseren Wärmeleitfähigkeit von Flüssigkeiten kann somit eine Kühlflüssigkeit zur Kühlung von Komponenten bereitgestellt werden, die eine vergleichsweise hohe Kühlleistung erfordern. Darüber hinaus ermöglicht es die verbesserte Wärmeleitfähigkeit der Flüssigkeit im Vergleich zu Luft, dass die Vorlauftemperatur der Flüssigkeit für die Flüssigkeitskühlung der Komponenten im Vergleich zu der Temperatur der Kühlluft höher gewählt werden kann. Die erfindungsgemäße Schaltschrankanordnung ermöglicht daher die Kühlung auf mindestens zwei unterschiedlichen Temperaturniveaus.

Der Kühlkreislauf kann mindestens ein Kühlmittel, oder ein Kältemittel, oder ein sonstiges Kühlmedium aufweisen, welches zumindest anteilig flüssig und in dem Kreislauf zirkuliert ist.

Die durch den Luft-Flüssigkeit-Wärmeübertrager geleitete Flüssigkeit kann Wasser oder eine größtenteils Wasser aufweisende Flüssigkeit sein.

Erfindungsgemäß ist eine Schaltschrankanordnung mit mindestens einem IT-Rack oder Schaltschrankgehäuse vorgesehen, wobei durch das IT-Rack oder Schaltschrankgehäuse Luft zur Kühlung von in dem IT-Rack oder Schaltschrankgehäuse aufgenommenen Komponenten hindurchgeleitet ist. Dabei ist von der Luft ein zweiter Luft-Flüssigkeit-Wärmeübertrager eines zweiten Kühlkreislaufes beaufschlagt und eine durch den Luft-Flüssigkeit-Wärmeübertrager geleitete Flüssigkeit ist mindestens einer der Komponenten für die Wärmeübertragung von der Komponente auf die Flüssigkeit zugeleitet und von der Komponente zurück in den Luft-Flüssigkeit-Wärmeübertrager abgeleitet.

Die Luft kann von außerhalb der Schaltschrankanordnung teilweise in das mindestens eine IT-Rack oder das Schaltschrankgehäuse und teilweise in ein dem IT-Rack oder dem Schaltschrankgehäuse beigeordnetes und davon fluidisch getrenntes Kühlgerätegehäuse, in welchem der Luft-Flüssigkeit-Wärmeübertrager aufgenommen ist, eingeleitet sein. Dazu kann der Luft-Flüssigkeit-Wärmeübertrager in einem Kühlgerätegehäuse angeordnet sein, welches dem IT-Rack oder dem Schaltschrankgehäuse beigeordnet ist. In dem Kühlgerätegehäuse kann weiterhin ein Luft-Flüssigkeit-Wärmeübertrager eines weiteren Kältemittelkreislaufs angeordnet sein, beispielsweise eines Wasserkreislaufes, bei dem über einen Rückkühler, beispielsweise einen Chiller, gekühltes Wasser für die Bereitstellung von gekühlter Luft mithilfe des weiteren Luft-Flüssigkeit-Wärmeübertragers zur Verfügung gestellt ist. Derjenige der beiden Luft-Flüssigkeit-Wärmeübertrager, über welchen die gekühlte Flüssigkeit für die Direktkühlung der Komponenten bereitgestellt ist, kann in dem Luftstrom, welcher durch das Schaltschrankgehäuse geleitet ist, stromabwärts zu dem Luft-Flüssigkeit-Wärmeübertrager angeordnet sein, welcher gekühlte Luft für die Luftkühlung der Komponenten zur Verfügung stellt. Insbesondere kann in der zuvor beschriebenen Weise die Flüssigkeitsdirektkühlung der Komponenten mithilfe eines Kältemittels realisiert sein, welches einen höheren Siedepunkt im Vergleich zu der Luft aufweist, welche üblicherweise zur Luftkühlung von Komponenten etwa einer IT-Umgebung verwendet wird. Beispielsweise kann die gekühlte Luft, die die Komponenten beaufschlagt, eine Temperatur aufweisen, die 25 °C beträgt, während der Siedepunkt des Kältemittels mehr als 50 °C beträgt.

Die Luft kann von außerhalb der Schaltschrankanordnung in das mindestens eine IT-Rack oder das Schaltschrankgehäuse eingeleitet sein, wobei die Schaltschrankanordnung eine Luftführung aufweist, bei der die Luft in ihrer Strömungsrichtung nach dem Eintritt in das IT-Rack oder das Schaltschrankgehäuse die Komponenten beaufschlagt, bevor sie als durch die Komponenten teilweise erwärmte Luft den Luft-Flüssigkeit-Wärmeübertrager beaufschlagt. Wie bereits zuvor beschrieben wurde, kann aufgrund des vergleichsweise hohen Siedepunkts des Kältemittels für die Komponentenflüssigkeitskühlung auch die bereits nach dem Passieren der Komponenten vorgewärmte Luft immer noch dazu verwendet werden, das Kältemittel zu kondensieren. Beispielsweise kann die Kühlluft beim Eintreten in das IT-Rack oder das Schaltschrankgehäuse eine Temperatur von 25 °C aufweisen. Nach dem Passieren der Komponenten kann sie eine Temperatur von 35 °C aufweisen. Nach dem Passieren des Luft-Flüssigkeit-Wärmeübertragers kann die Luft eine Temperatur von mehr als 50 °C aufweisen.

Der Luft-Flüssigkeit-Wärmeübertrager des zweiten Kreislaufs kann in einer einwandig oder doppelwandig ausgeführten Rücktür oder Vordertür des IT-Racks oder des Schaltschrankgehäuses angeordnet sein, wobei der Luft-Flüssigkeit-Wärmeübertrager von Luft durchströmt ist, die an einer der Rücktür oder der Vordertür gegenüber angeordneten Seite in das IT-Rack oder das Schaltschrankgehäuse eintritt.

Das IT-Rack oder das Schaltschrankgehäuse kann eine Luftführung aufweisen, bei der die Luft in ihrer Strömungsrichtung nach dem Eintritt in das IT-Rack oder das Schaltschrankgehäuse die Komponenten beaufschlagt, bevor sie als durch die Komponenten teilweise erwärmte Luft in die Rücktür oder die Vordertür eintritt und den Luft-Flüssigkeit-Wärmeübertrager des zweiten Kreislaufes beaufschlagt.

Der zweite Luft-Flüssigkeit-Wärmeübertrager kann ein Gehäuse mit einem zwischen einer Außenwand und einer rohrförmigen Innenwand ausgebildeten Ringspalt aufweisen, durch den die Flüssigkeit im thermischen Kontakt mit zumindest der Innenwand hindurchgeleitet ist. Dabei kann die Innenwand einen Lüfter umschließen, der dazu eingerichtet ist, die Luft an der Innenwand vorbei durch das Gehäuse hindurch zu leiten.

Ein Verfahren für die Klimatisierung einer Schaltschrankanordnung, kann die Schritte aufweisen:
- Beaufschlagen von in einem IT-Rack oder einen Schaltschrankgehäuse der Schaltschrankanordnung aufgenommenen Komponenten mit Luft, wobei die Luft auf eine erste Temperatur erwärmt wird, und
- Hindurchleiten der auf die erste Temperatur erwärmten Luft durch einen Luft-Flüssigkeit-Wärmeübertrager, wobei eine Flüssigkeit einer Flüssigkeitskühlung der Komponenten abgekühlt und die Luft auf eine zweite Temperatur erwärmt wird, die größer als die erste Temperatur ist.

Dabei kann die Luft nach dem Hindurchleiten durch den Wärmeübertrager mit der zweiten Temperatur in die Umgebung der Schaltschrankanordnung abgeleitet oder durch einen weiteren Wärmeübertrager abgekühlt und für das erneute Beaufschlagen der Komponenten mit Luft rezirkuliert werden.

Die Luft kann nach dem Hindurchleiten durch den Wärmeübertrager mit der zweiten Temperatur über einen Schornstein von der Schaltschrankanordnung weggeleitet werden. Der Schornstein kann der in einen weiteren Luft-Flüssigkeit-Wärmeübertrager münden, beispielsweise in einen weiteren Luft-Flüssigkeit-Wärmeübertrager, dem über einen Kaltwassersatz oder einen Chiller ein gekühltes, flüssiges Kühlmedium zugeführt wird.

Für die Wärmeübertragung von der zu kühlenden Komponente auf ein Kühlmittel, das insbesondere als eine Kühlflüssigkeit ausgebildet sein kann, kann eine Kühlanordnung für die Direktkühlung der Komponenten vorgesehen sein, beispielsweise eine Kühlanordnung für die Direktkühlung von Halbleiterbauelementen, wie CPUs. Die Anordnung kann mindestens einen einen Hohlraum aufweisenden Kühlkörper aufweisen, der von einem Kühlmittel durchströmt und dazu eingerichtet ist, mit seiner Unterseite ein Halbleiterbauelement wärmeleitend zu kontaktieren. Dabei kann der Kühlkörper einen in den Hohlraum mündenden Kühlmittelzulauf und einen in den Hohlraum mündenden Kühlmittelrücklauf aufweist. Der Kühlmittelzulauf kann dabei vorteilhafterweise oberhalb von dem Kühlmittelrücklauf angeordnet sein.

Der Kühlmittelzulauf kann ein verstellbares Schließorgan aufweisen, mit dem ein vertikaler Öffnungsquerschnitt des Kühlmittelzulaufs einstellbar ist. Das Schließorgan kann einen Schieber aufweisen, der linearverstellbar ist, wobei der Schieber vorzugsweise in Vertikalrichtung verstellbar ist und in einer untersten Stellung den Öffnungsquerschnitt freigibt und in einer obersten Stellung zumindest teilweise verschließt.

Der Kühlmittelzulauf kann über eine Kühlmittelpumpe mit dem Kühlmittel beaufschlagt ist. Die Pumpe kann das Kühlmittel als flüssiges Kühlmittel aus einem Kühlmittelsammelbehälter und über eine Kühlmittelzuführleitung dem Kühlmittelzulauf zugeleitet sein.

Eine Mehrzahl der Kühlkörper kann fluidisch parallel geschaltet sein, indem die Kühlkörper über ihren jeweiligen Kühlmittelzulauf an dieselbe Kühlmittelzuführleitung angeschlossen sind. Der mindestens eine Kühlkörper kann über seinen Kühlmittelrücklauf an eine Kondensationszone angeschlossen sein, in der über den Kühlmittelrücklauf austretendes und zumindest teilweise verdampftes Kühlmittel abgekühlt ist. Die Kondensationszone kann einen Flüssigkeit-Flüssigkeit-Wärmeübertrager aufweisen, durch den entlang eines ersten Kühlmittelkreislaufs das durch den mindestens einen Kühlkörper geleitete Kühlmittel geleitet ist. Eine durch einen zweiten Kühlmittelkreislauf des Flüssigkeit-Flüssigkeit-Wärmeübertragers geleitete Flüssigkeit kann Wasser oder eine größtenteils Wasser aufweisende Flüssigkeit sein. Das durch den mindestens einen Kühlkörper geleitete Kühlmittel kann unter Standardbedingungen einen Siedepunkt aufweisen, der unterhalb des Siedepunkts der Flüssigkeit liegt, die durch einen zweiten Kühlmittelkreislauf des Flüssigkeit-Flüssigkeit-Wärmeübertragers geleitete ist, vorzugsweise mindestens 20 K, besonders bevorzugt mindestens 30 K und ganz besonders bevorzugt mindestens 40 K unterhalb des Siedepunkts der Flüssigkeit.

Die Kondensationszone, in welche der mindestens eine Kühlmittelrücklauf mündet, kann ein Gefälle aufweisen, wobei ein Kühlmittelsammelbehälter, aus dem das Kühlmittel über eine Kühlmittelzuführleitung dem Kühlmittelzulauf zugeleitet ist, unterhalb sämtlicher Kühlkörper angeordnet ist.

Das Kühlmittel kann eine perfluorierte chemische Verbindung sein oder aufweisen, vorzugsweise eine vom Ethylisopropylketon abgeleitete Verbindung, besonders bevorzugt Perfluor(2-methyl-3-pentanon), C₆F₁₂O.

Der Kühlmittelrücklauf kann einen vertikalen Öffnungsquerschnitt aufweisen, der größer als ein maximaler Öffnungsquerschnitt des Kühlmittelzulaufs ist.

Der Kühlmittelrücklauf kann druckfrei sein, so dass das Kühlmittel über den Kühlmittelrücklauf ungehindert ablaufen kann.

Der Kühlmittelrücklauf kann unter einem Abstand zu einer unteren Begrenzungswand des Hohlraums angeordnet sein, wobei durch den Abstand eine Füllhöhe des Kühlmittels in dem Hohlraum über der unteren Begrenzungswand vorgegeben ist, und wobei durch einen weiteren Abstand des Kühlmittelrücklaufs zu einer der unteren Begrenzungswand gegenüber angeordneten oberen Begrenzungswand ein Verdampfungsvolumen des Hohlraums bestimmt ist.

Weitere Einzelheiten der Erfindung werden anhand der nachstehenden Figuren erläutert. Diese zeigen lediglich beispielhafte Ausführungsformen, die die Erfindung nicht beschränken sollen. Dabei zeigt:
- Figur 1: eine Schaltschrankanordnung gemäß dem Stand der Technik;
- Figur 2: eine beispielhafte Ausführungsform einer nicht erfindungsgemäßen Schaltschrankanordnung;
- Figur 3: eine weitere Ausführungsform einer nicht erfindungsgemäßen Schaltschrankanordnung;
- Figur 4a-4c: drei beispielshafte Ausführungsformen einer erfindungsgemäßen Schaltschrankanordnung mit unterschiedlicher relativer Anordnung des Kühlgeräts zum Schaltschrankgehäuse;
- Figur 5: in schematischer Darstellung verschiedene Varianten der Verschaltung eines Luft-Flüssigkeit-Wärmeübertragers mit einem Flüssigkeit-Flüssigkeit-Wärmeübertrager;
- Figur 6: in schematischer Darstellung den Wärmeübergang zwischen einer zu kühlenden Komponente und einem Wärmeleitkörper gemäß einer ersten Ausführungsform;
- Figur 7: in schematischer Darstellung den Wärmeübergang zwischen einer zu kühlenden Komponente und einem Wärmeleitkörper gemäß einer zweiten Ausführungsform;
- Figur 8: in schematischer Darstellung den Wärmeübergang zwischen einer zu kühlenden Komponente und einem Wärmeleitkörper gemäß einer dritten Ausführungsform;
- Figur 9: in schematischer Darstellung eine weitere Ausführungsform der erfindungsgemäßen Schaltschrankanordnung;
- Figur 10: in schematischer Darstellung noch eine weitere Ausführungsform einer erfindungsgemäßen Schaltschrankanordnung;
- Figur 11: in schematischer Darstellung eine beispielhafte Ausführungsform eines Sammelrohrs;
- Figur 12: in schematischer Darstellung weitere Ausführungsformen eines Sammelrohrs;
- Figur 13: in schematischer Darstellung noch eine Ausführungsform eines Sammelrohrs;
- Figur 14: in schematischer Darstellung eine weitere Ausführungsform eines Sammelrohrs;
- Figur 15: in schematischer Darstellung eine weitere Ausführungsform eines Sammelrohrs;
- Figur 16: in schematischer Darstellung eine weitere Ausführungsform eines Sammelrohrs;
- Figur 17: in perspektivischer Darstellung eine beispielhafte Ausführungsform eines Flüssigkeit-Flüssigkeit-Wärmeübertragers,
- Figur 18: in perspektivischer Darstellung den Wärmeübertrager nach Figur 17 mit Blick auf die Schnittebene C;
- Figur 19: den Wärmeübertrager gemäß Figur 17 mit Blick auf die Schnittebene B; und
- Figur 20: den Wärmeübertrager gemäß Figur 17 mit Blick auf die Schnittebene A.
- Figur 21: in schematische Darstellung eine Veranschaulichung der Fluidströme der Ausführungsform gemäß Figur 3;
- Figur 22: eine weitere Ausführungsform einer nicht erfindungsgemäßen Schaltschrankanordnung;
- Figur 23: in schematische Darstellung eine Veranschaulichung der Fluidströme der Ausführungsform gemäß Figur 22;
- Figur 24: eine weitere Ausführungsform einer erfindungsgemäßen Schaltschrankanordnung;
- Figur 25: in schematische Darstellung eine Veranschaulichung der Fluidströme der Ausführungsform gemäß Figur 24;
- Figur 26: eine weitere Ausführungsform einer erfindungsgemäßen Schaltschrankanordnung; und
- Figur 27: in schematische Darstellung eine Veranschaulichung der Fluidströme der Ausführungsform gemäß Figur 26;

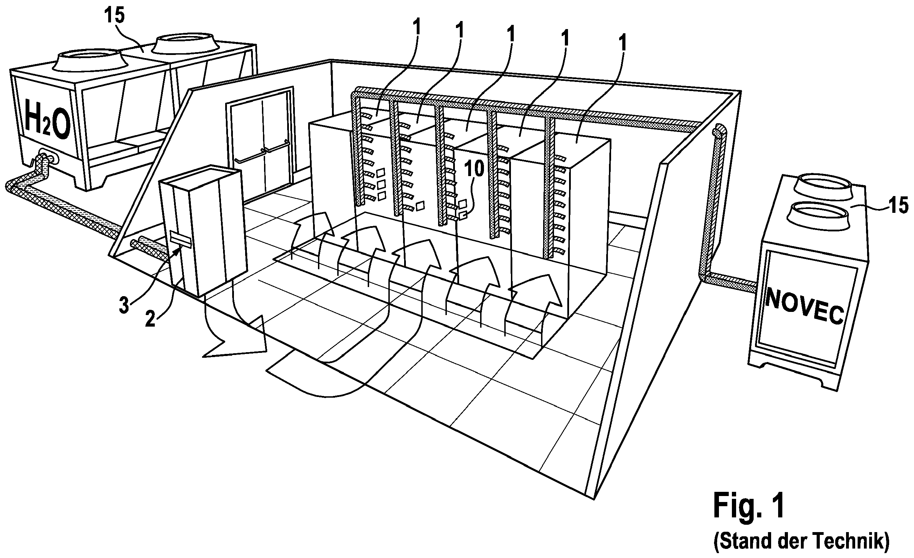

Die Figur 1 zeigt eine Schaltschrankanordnung nach dem Stand der Technik. Über einen außerhalb eines Gebäudes, beispielsweise eines Rechenzentrums angeordneten Rückkühler 15, der beispielsweise als ein Chiller ausgebildet sein kann, ist eine erste gekühlte Flüssigkeit, vorliegend Wasser, bereitgestellt und einem in dem Rechenzentrum angeordneten Kühlgerät 2 zur Verfügung gestellt. Das Kühlgerät 2 weist einen Luft-Flüssigkeit-Wärmeübertrager 3 auf, über den Kühlluft bereitgestellt ist, die in einen Doppelboden des Rechenzentrums eingeblasen ist. Aus dem Doppelboden wird die Kühlluft vor die Schaltschrankgehäuse bzw. IT-Racks 1 geblasen, so dass die Kühlluft von darin angeordneten Komponenten, beispielsweise von Server-Einschüben, angesogen werden kann. Alternativ oder zusätzlich können die Schaltschränke 1 eine einen Warmgang von einem Kaltgang des Rechenzentrums trennende Schaltschrankreihe bilden, wobei über in den Doppelböden angeordneten Lüftern ein Kaltluftüberdruck im Kaltgang bereitgestellt ist, welcher die Kühlluft durch die Schränke 1 in den Warmgang als erwärmte Luft transportiert und dabei die in den Schränken 1 angeordneten Komponenten kühlt.

Zusätzlich zu der Luftkühlung ist eine Flüssigkeitskühlung bereitgestellt, beispielsweise eine CPU-Flüssigkeitskühlung, wozu ein weiterer Rückkühler 15, welcher ein Kältemittelt verflüssigt, das beispielsweise eine Siedetemperatur aufweisen kann, welche nahe bei einer bevorzugten Betriebstemperatur kühlungsbedürftiger Komponenten liegen kann. Wenn somit das Kältemittel den kühlungsbedürftigen Komponenten zugeführt wird, kann die von diesen erzeugte Verlustleistung zur Verdampfung des Kältemittels führen, so dass aufgrund des Phasenübergangs von flüssig zu gasförmig ein besonders hoher Wärmeübergang von der Komponente in das Kältemittel und damit eine effektive Kühlung erfolgt. Der Wärmeübergang von dem Kältemittel zu den Komponenten wird mit Hilfe von Wärmeleitkörpern 10 gefördert, welche unmittelbar mit der zu kühlenden Komponente in Kontakt stehen. Die Wärmeleitkörper 10 können im Wesentlichen aus einem sehr gut wärmeleitfähigen Material, beispielsweise aus einem Metall bestehen, das einen Kühlkörper bildet, durch welchen das Kältemittel hindurchgeleitet ist und welches ggf. innerhalb des Wärmeleitkörpers 10 den bereits beschriebenen Phasenübergang flüssig zu gasförmig erfährt, wobei das Kältemittel vorzugsweise mit einer Durchlaufgeschwindigkeit bzw. mit einem Durchflussvolumen und einer Temperatur bereitgestellt sind, welche derart gewählt sind, dass nur eine Teilmenge des durchgeleiteten Kältemittelvolumenstroms verdampfen und ein weiterer Teil flüssig bleibt, so dass der verdampfte Teil von dem flüssigen Teil nachströmenden Kältemittels heraustransportiert werden kann, um in dem Rückkühler 15 wieder verflüssigt zu werden.

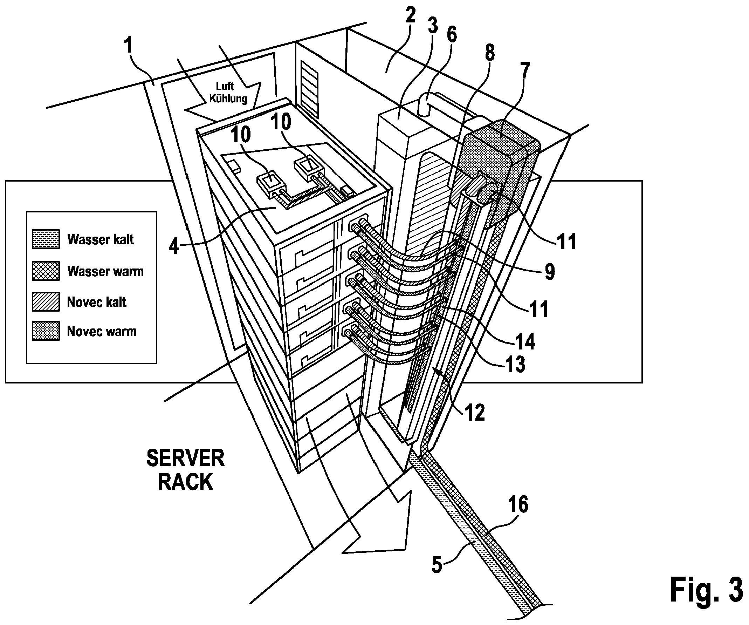

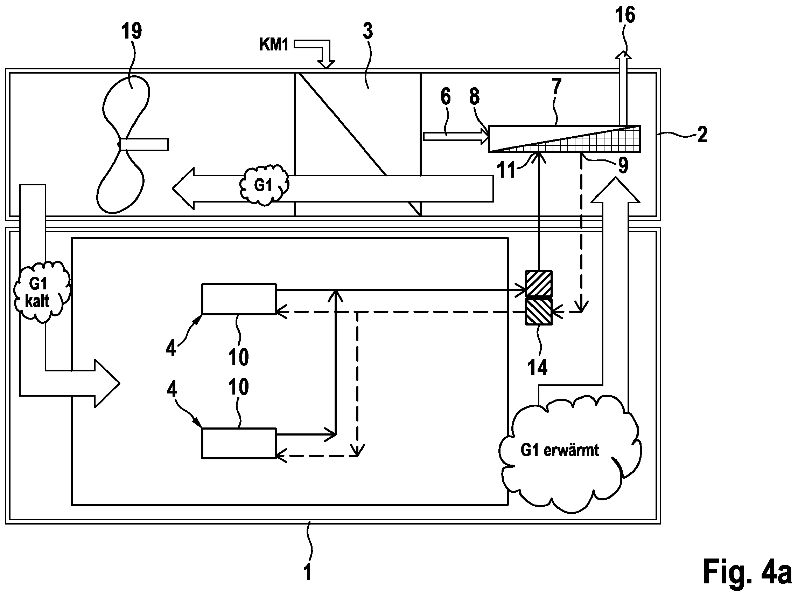

Demgegenüber zeigen die Figuren 4a bis 5 beispielhafte Ausführungsformen einer erfindungsgemäßen Schaltschrankanordnung. Bei der in Figur 3 gezeigten Ausführungsform wird dem Kühlgerät 2 über einen ersten Vorlauf 5 eine erste gekühlte Flüssigkeit, beispielsweise Wasser, zugeleitet, mit welcher der Wärmetauscher 3 durchströmt wird. Der Wärmetauscher 3 weist dazu einen ersten Rücklauf 6 auf, welcher nunmehr erfindungsgemäß abweichend von der Lösung gemäß Figur 1 nicht unmittelbar in den Rückkühler 15 mündet, sondern an einen Vorlauf 8 eines Flüssigkeit-Flüssigkeit-Wärmeübertragers 7 angeschlossen ist. Der Wärmeübertrager 7 weist einen zweiten Rücklauf 16 auf, welcher analog zu der Ausführungsform gemäß Figur 1 einem Rückkühler 15 zugeleitet ist. Über den Flüssigkeit-Flüssigkeit-Wärmeübertrager 7 erfolgt ein Wärmeübergang zwischen dem Flüssigkeitskreislauf des Luft -Flüssigkeit-Wärmeübertragers und einem zweiten davon fluidisch getrennten Kältemittelkreislaufs, der beispielsweise ein Kältemittel mit einem abweichenden Siedepunkt aufweisen kann, wie dies bereits mit Bezug auf Figur 1 beschrieben worden ist. Da der zweite Kältemittelkreislauf auf einem Temperaturniveau betrieben werden kann, der oberhalb von dem des ersten Kältemittelkreislaufs mit dem Luft-Flüssigkeit-Wärmeübertrager 3 liegt, kann die über den ersten Rücklauf 6 bereitgestellte erwärmte Flüssigkeit als Kühlflüssigkeit dienen, die in den Flüssigkeit-Flüssigkeit-Wärmeübertrager 7 eingeleitet wird.

Die Figuren 4a bis 4c zeigen drei unterschiedliche relative Anordnungen eines Kühlgerätegehäuses 2 in Bezug auf ein Schaltschrankgehäuse 1. Aus der sich voneinander unterscheidenden relativen Anordnung der beiden Komponenten 1, 2 zueinander ergibt sich eine unterschiedliche Luftführung. Insbesondere sind somit erfindungsgemäß sowohl Ausführungsformen denkbar, bei denen die über den Luft-Kältemittel-Wärmetauscher 3 gekühlte und die kühlbedürftigen Komponenten 4 überströmende Luft lediglich zwischen dem Kühlgerät und dem Schaltschrankgehäuse zirkuliert, d. h. fluidisch abgetrennt von der Umgebung der Schaltschrankanordnung einen geschlossenen Luftkreislauf ausbilden. Andererseits ergeben sich Anordnungen, bei denen grundsätzlich unterschiedliche Luftströme einerseits das Schaltschrankgehäuse 1 und andererseits das Kühlgerät 2 durchströmen, wobei diese Anordnungen insbesondere bei sogenannten Kaltgang-Warmgang-Konstellationen in Rechenzentren und dergleichen Anwendung finden.

Im Einzelnen zeigt die Figur 4a eine Anordnung, bei der die Luft ausschließlich zwischen den unmittelbar aneinander grenzenden und fluidisch miteinander in Verbindung stehenden Gehäusen von Kühlgerät 2 und Schaltschrank 1 zirkuliert. Die über den Luft-Kältemittel-Wärmetauscher 3 gekühlte Luft wird von einem Lüfter 19 durch den Wärmetauscher 3 gesogen und in das Schaltschrankgehäuse 1 gedrückt, wozu sie an einer Rückseite des Schaltschrankgehäuses 1 seitlich in das Schaltschrankgehäuse 1 eingeblasen wird. Die Kühlluft durchströmt in im Wesentlichen horizontaler Richtung das Schaltschrankgehäuse 1 und umströmt dabei die kühlbedürftigen Komponenten 10, woraufhin sie an der Vorderseite des Schaltschrankgehäuses 1 als erwärmte Luft wiederum über einen seitlichen, fluidischen Luftübergang in das Kühlgerät 2 eintritt, um den Luft-Kältemittel-Wärmetauscher 3 erneut zu durchströmen.

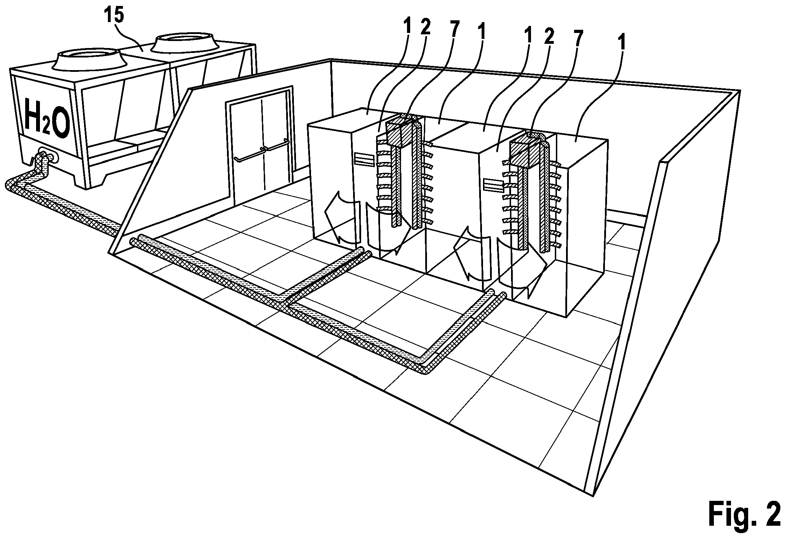

In der bereits beschriebenen Weise ist der Kältemitterücklauf des Luft-Kältemittel-Wärmetauschers 3 an einen Vorlauf 8 des Kältemittel-Kältemittel-Wärmetauschers 7 angeschlossen, wobei das den Luft-Kältemittel-Wärmetauscher 3 als teilerwärmtes Kältemittel KM1 verlassene Kältemittel nach dem Passieren des Flüssigkeit-Flüssigkeits-Wärmetauscher 7 letzteren über den Rücklauf 16 verlässt um beispielsweise über einen externen Rückkühler (vergleiche Figur 2) rückgekühlt zu werden. Das Kältemittel KM1 kann beispielsweise Wasser sein.

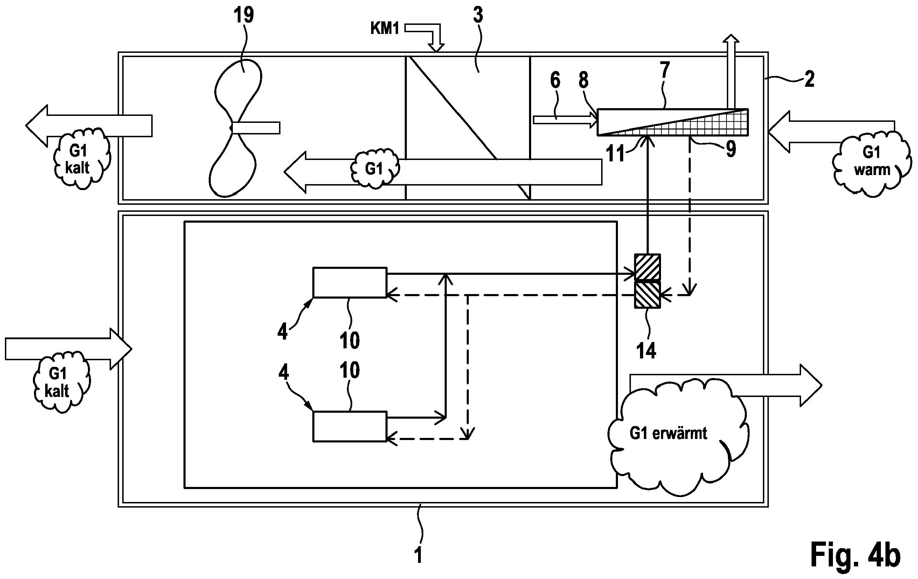

Abweichend von der in Figur 4a gezeigten Ausführungsform ist bei der in Figur 4b gezeigten Ausführungsform kein luftfluidischer Übergang zwischen den Gehäusen von Schaltschrank 1 und Kühlgerät 2 vorgesehen, wobei beide Gehäuse antiparallel von Umgebungsluft durchströmt werden. Die Umgebungsluft kann beispielsweise die Luft sein, welche in einer Kaltgang-Warmgang-Anordnung zwischen den Schaltschrankreihen aufgenommen ist. So kann beispielsweise das Schaltschrankgehäuse in der aus dem Stand der Technik bekannten Weise die über die Rückseite angesogene Kaltluft als erwärmte Luft über seine Vorderseite ausströmen. Bei der erfindungsgemäßen Anordnung gemäß Figur 4b kann nunmehr vorgesehen sein, dass die Warmluft aus dem Warmgang über die Vorderseite des Kühlgerätegehäuses 2 in das Kühlgerät eintritt, wo sie den Flüssigkeit-Luft-Wärmetauscher 3 passiert und als gekühlte Luft in den Kaltgang an der Rückseite der Anordnung eintritt. Die gekühlte Luft im Kaltgang kann wiederholt über die Rückseite des Schaltschrankgehäuses in das Schaltschrankgehäuse eintreten, um die kühlbedürftigen Komponenten 4 zu überströmen.

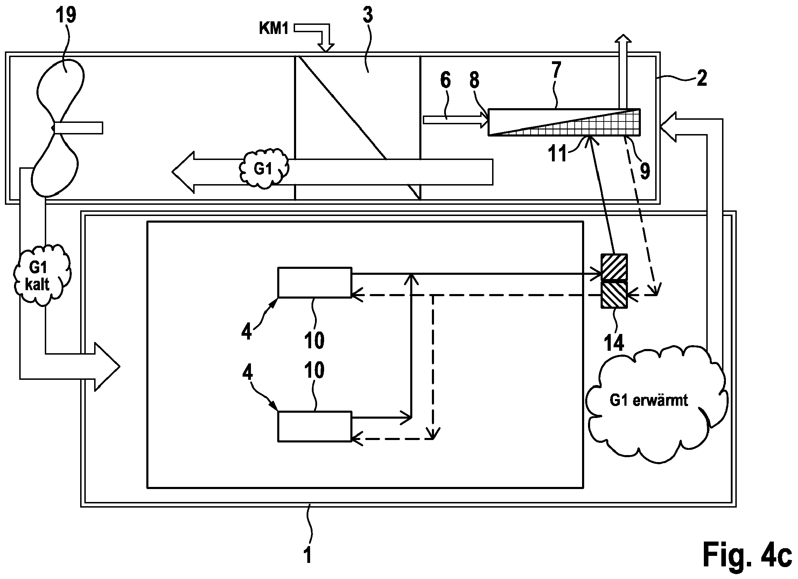

Die Ausführungsform gemäß die Ausführungsform gemäß Figur 4c unterscheidet sich von der Ausführungsform gemäß Figur 4b darin, dass die Gehäuse von Kühlgerät 2 und Schaltschrank 1 in horizontaler Richtung einen Versatz aufweisen, wobei die an der Rückseite des Kühlgerätegehäuses 2 seitlich austretende, gekühlte Luft über die Rückseite in den Schaltschrank 1 eintritt. In der bereits beschriebenen Weise überströmt die gekühlte Luft die kühlbedürftigen Komponenten 4 und wird dabei erwärmt. An der Vorderseite des Schaltschrankgehäuses tritt die erwärmte Luft wiederum seitlich aus dem Schaltschrank 1 aus, um unmittelbar vor die Vorderseite des Kühlgerätgehäuses 2 geblasen zu werden, wo sie über den Lüfter 19 erneut in das Gehäuse 2 eingezogen und durch den Luft-Kältemittel-Wärmetauscher 3 transportiert werden kann, um die Luft anschließend wieder als gekühlte Luft seitlich an der Rückseite des Kühlgerätegehäuses 2 unmittelbar vor die Rückseite des Schaltschrankgehäuses 1 auszublasen.

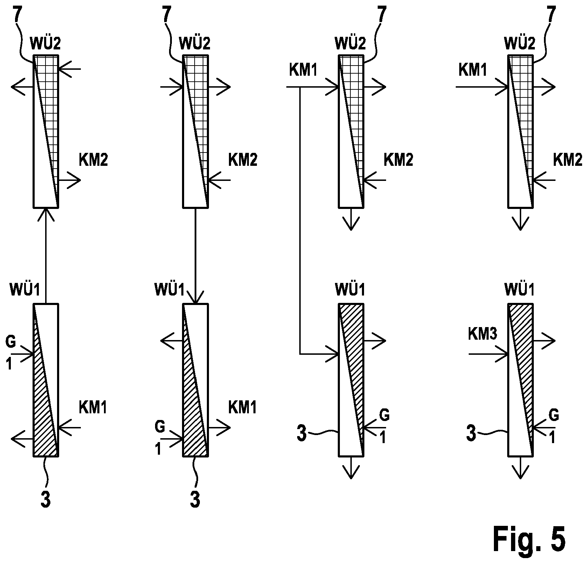

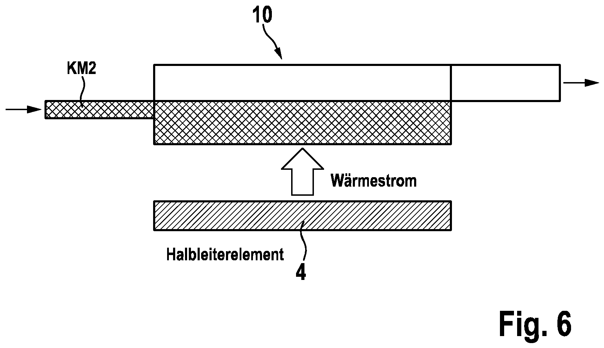

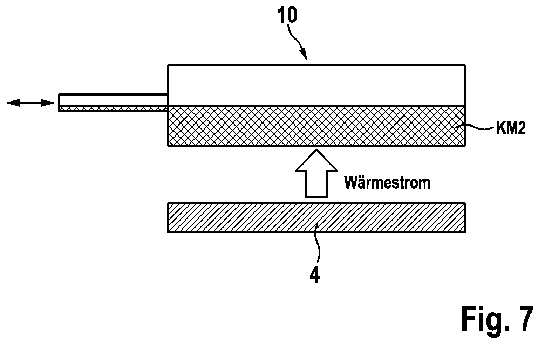

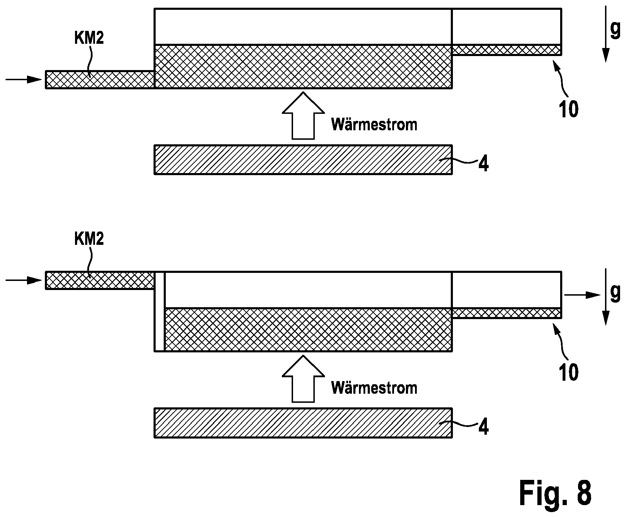

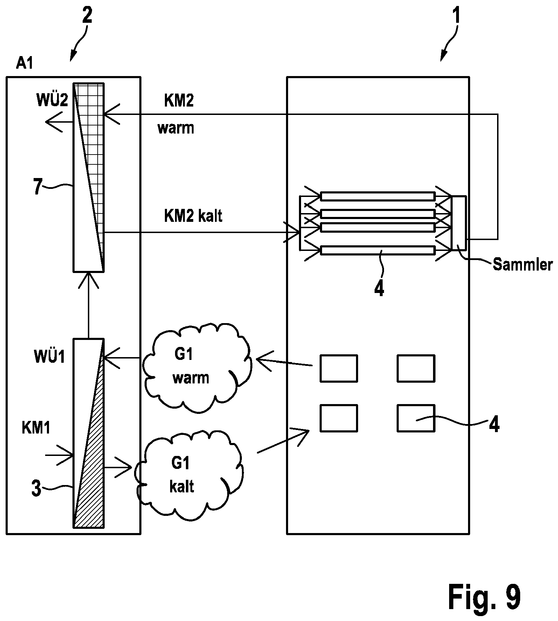

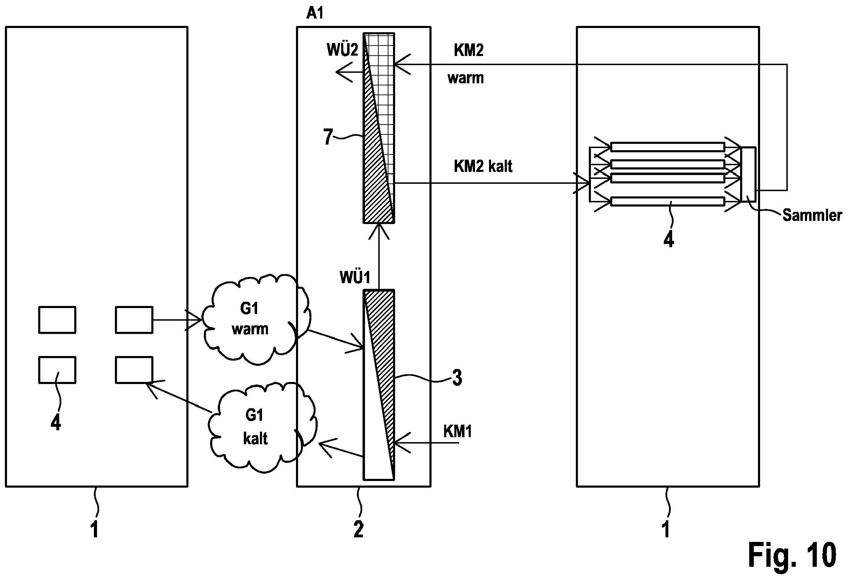

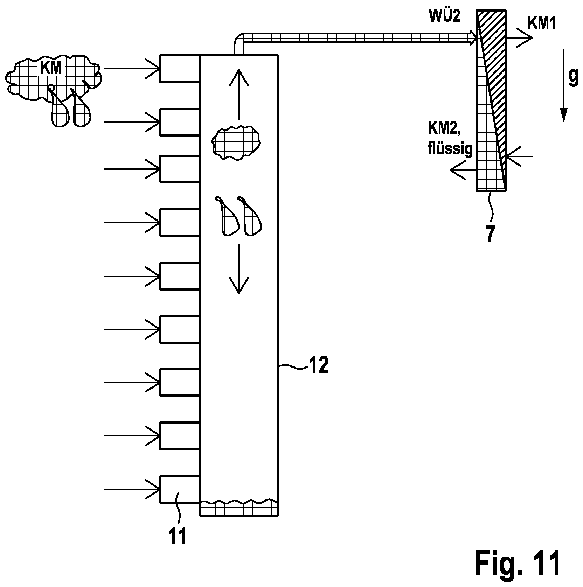

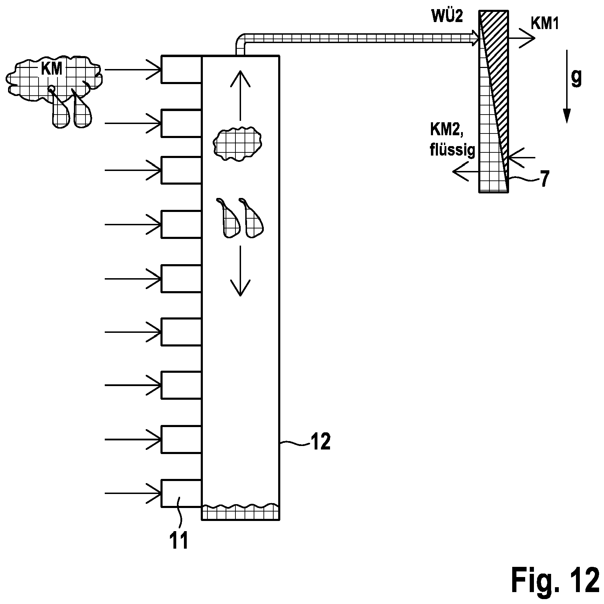

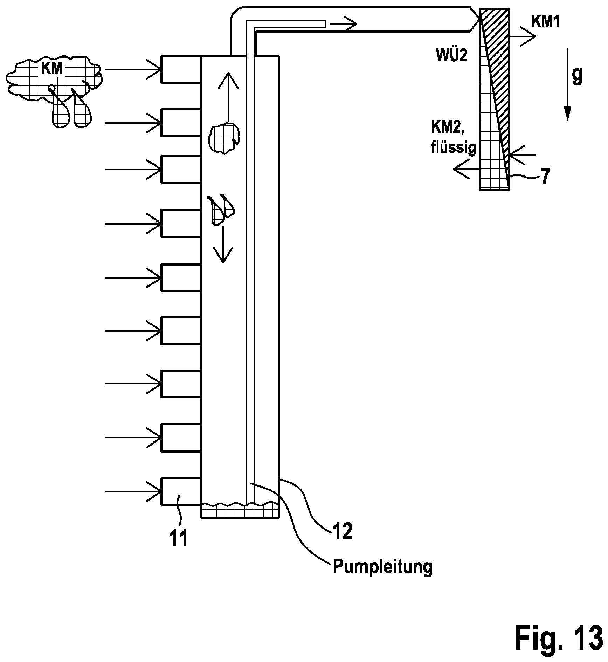

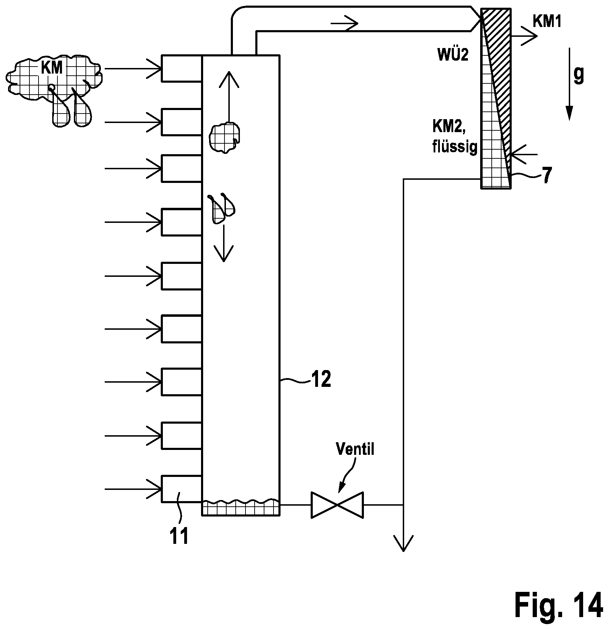

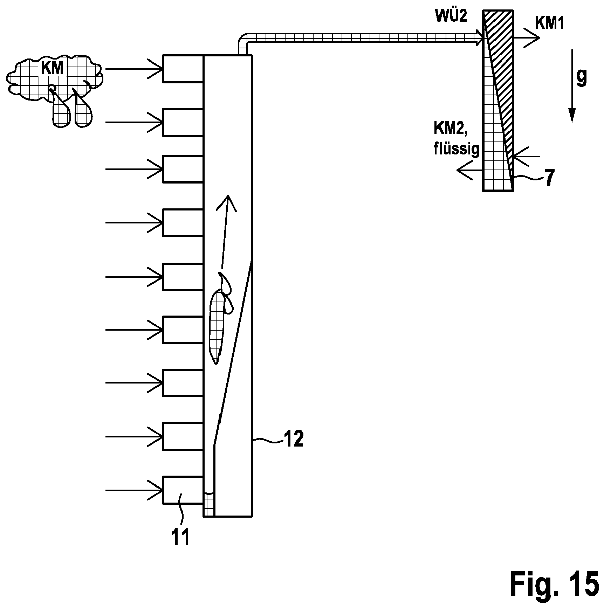

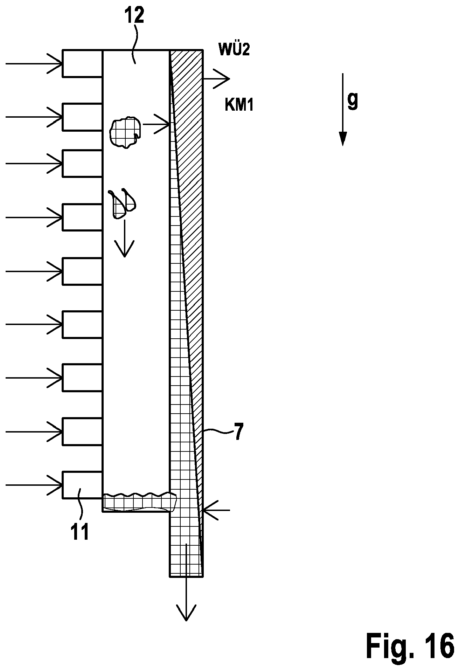

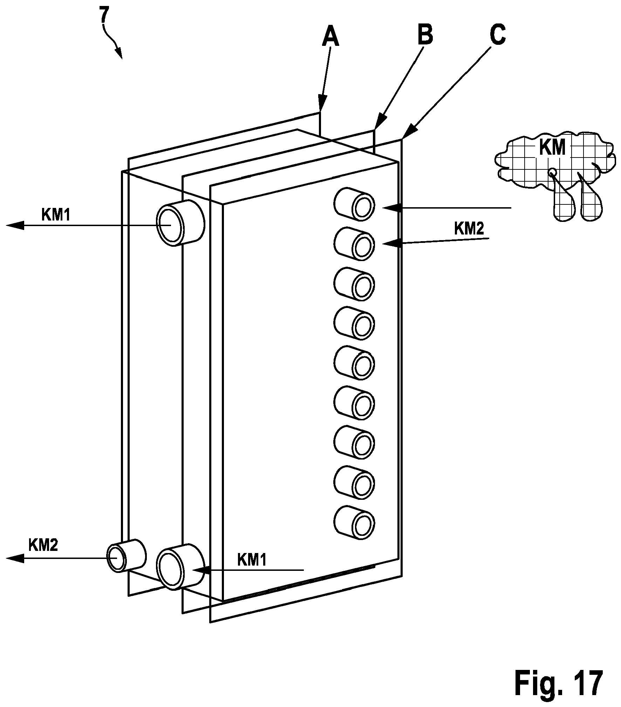

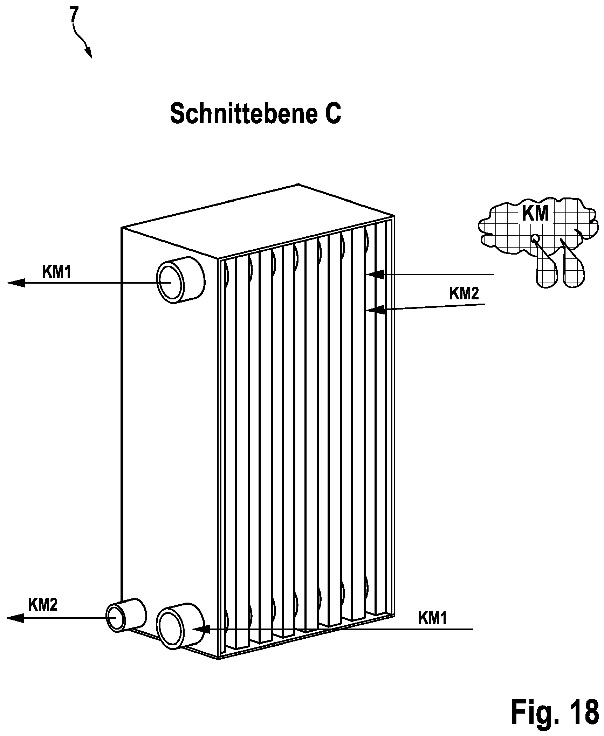

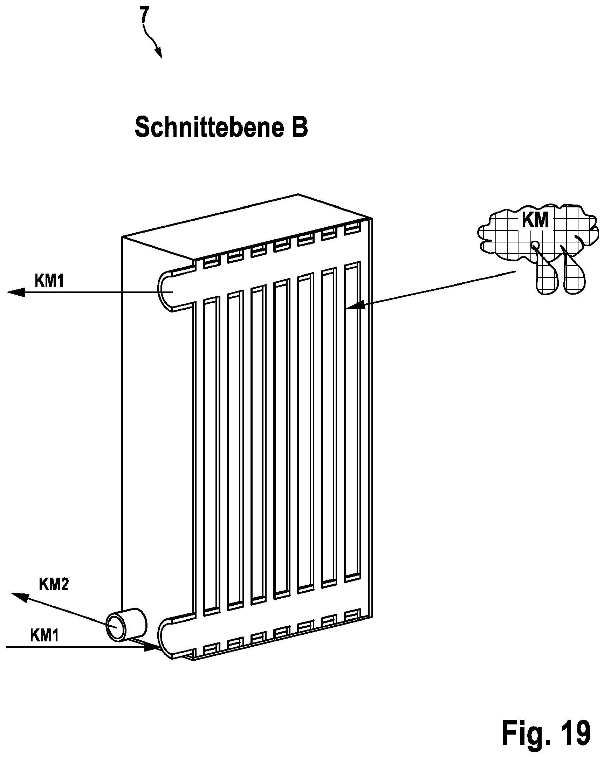

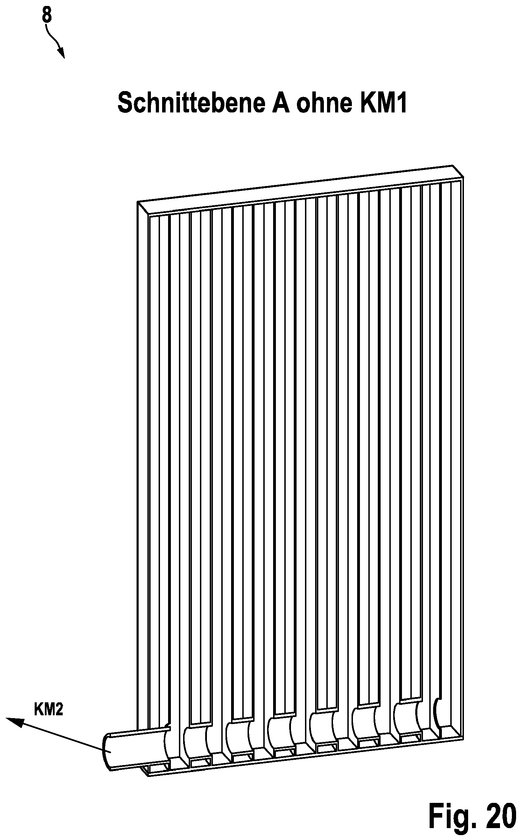

In den weiteren Figuren 5 bis 20 wird beispielhaft die Kühlung von Wärme abgebenden elektrisch betriebenen Komponenten in einer im wesentlichen geschlossenen Einhausung gezeigt, wobei das Medium G1 durch Komponente A1 mit einem Luft- oder Gaskühler WÜ1, mit dem Kühlmedium KM1 gekühlt wird und G1 hauptsächlich zwischen Kühlung und sich in den in der Einhausung befindlichen elektrisch betriebenen Objekten hin und her strömt. G1 wird dabei in einem angrenzend zur Einhausung und/oder in der Einhausung stehenden und/oder durch mit der Einhausung im Wesentlichen geschlossenen Kanälen (Blechkanäle, Schläuche oder auch Bürsten) verbundenem Gerät oder Komponente (A1) gekühlt. Mit A1 können eine oder mehrere Einhausungen wie IT-Racks oder Schaltschrankgehäuse gekühlt werden. KM1 kann aus einem festen oder flüssigen oder gasförmigen oder mehrphasigen oder die Phasen ganz oder teilweise wechselnden kühleren Material aus einem oder mehreren Stoffen bestehen. KM1 kann vorzugsweise Wasser oder Wasser mit Additiven oder ein Kältemittel mit gegenüber Wasser verringerter Kondensationstemperatur sein.

Zusätzlich zur Kühlung von G1 erfolgt eine weitere Kühlung eines zweiten Kühlmediums KM2 durch Komponente A1. KM2 kann aus einem festen oder flüssigen oder gasförmigen oder mehrphasigen oder die Phasen ganz oder teilweise wechselnden kühleren im Wesentlichen dielektrischen Material aus einem oder mehreren Stoffen bestehen. Dies kann vorzugsweise 1,1,1,2,2,4,5,5,5-Nonafluoro-4-(Trifluoromethyl)-3-pentanon oder 1,1,1,2,2,3,3-Heptafluoro-3-methoxypropan mit verschiedenen möglichen Reinheitsgraden (hochrein oder verunreinigt) sein.

Die Kühlung von KM2 findet durch KM1 mittels eines Wärmeübertragers WÜ2, mit oder ohne Vermischung von KM1 und KM2, statt. KM1 kann zuerst Komponenten oder Gerät G1 und danach Kühlmedium KM2 abkühlen oder umgekehrt oder parallel.

In einer weiteren Ausprägung kann G1 oder KM2 auch in einem getrennten Kreislauf durch ein Kühlmedium KM3 gekühlt werden. KM3 kann aus einem festen oder flüssigen oder gasförmigen oder mehrphasigen oder die Phasen ganz oder teilweise wechselnden kühleren im Wesentlichen dielektrischen Material aus einem oder mehreren Stoffen bestehen. KM3 kann vorzugsweise Wasser oder Wasser mit Additiven oder Kältemittel sein.

KM2 wird dann als wiederum kühlender Stoff für mindestens ein elektrisch betriebenes Gerät oder eine solche Komponente, die noch wärmer werden kann als KM2 (insbesondere Halbleiterelemente, etwa CPUs) mittels eines geeigneten Kanals, insbesondere mindestens eines Rohrs und/oder Schlauchs, bereitgestellt.

Dabei befindet sich das mindestens eine zu kühlende elektrisch betriebene Gerät oder die Komponente in einer Einhausung und wird mit KM2 gekühlt, wobei sich andere elektrisch betriebene Geräte oder Komponenten in der gleichen oder einer anderen Einhausung befinden könne, die mit G1 gekühlt werden.

Die Bereitstellung des Kühlmediums erfolgt insbesondere durch hydraulisch kommunizierende Röhren, ein Drahtgestrick oder eine Pumpe, insbesondere eine elektrisch oder pneumatisch angetriebene Pumpe oder eine thermisch angetriebene Blasenpumpe oder eine Kombination davon. Hierbei ist die Kühltemperatur von KM2 in besonderen Ausführungen auf die maximal zulässige oder wirtschaftlich optimale Kühltemperatur der zu kühlenden Komponente abgestimmt. Die Kühltemperatur kann insbesondere durch Druckänderung zur Kondensationstemperaturänderung oder durch die Wahl des Kühlmediums KM2 angepasst werden.

Das Kühlmedium KM2 wird durch das mindestens eine zu kühlende Objekt erwärmt oder nicht erwärmt. Die Phase von KM2 wird ganz oder teilweise gewechselt (insbesondere ganz oder teilweise verdampft), durch denselben Kanal oder eine oder mehrere andere Kanäle wieder abgeführt. Falls die Komponente keine Wärme abgibt, kann die Bereitstellung von KM2 durch eine Regelung irgendeiner Art ganz oder teilweise gestoppt sein oder weiterlaufen. KM2 kann im Kanal laufen, stehen oder die Leitung kann leerlaufen. Die Zuführung von KM2 kann ungeregelt erfolgen und zwar so, dass immer KM2 durch den Kühler läuft und verdampft oder über eine Überlaufkante abläuft.

Auf dem Halbleiterbauelement ist ein gut wärmeleitender Hohlkörper angebracht, der mit einer elektrisch nichtleitenden Flüssigkeit mit geeigneter Verdampfungstemperatur befüllt ist. Um sicherzustellen, dass über der zur Entwärmung vorgesehenen Chipfläche immer ein ausreichender Flüssigkeitsspiegel vorhanden ist, kann der Hohlkörper wie folgt ausgeführt sein:

Der Hohlkörper besitzt einen Zulauf und einen Ablauf, wobei der Ablauf so ausgeführt ist das im Regelbetrieb, über der Ablauföffnung ein nicht mit Kühlmittel gefülltes Volumen verbleibt. Dazu ist der Zulauf durch eine geeignete Blende in der Leitung so begrenzt, dass immer mehr Kühlflüssigkeit in den Hohlkörper gelangt, als bei maximaler Wärmeeinleitung verdampfen kann. Der Ablauf hingegen ist so groß gestalten, dass immer mehr Kühlmittel in flüssiger sowie auch in gasförmiger Phase austreten kann, als durch den Zulauf eingeleitet wird.

Zuleitung und Ableitung der Kühlkörper werden so ausgeführt, dass immer ein vertikales Gefälle vorhanden ist um sicherzustellen, dass die Verdampfung im Hohlkörper nicht durch im Ablauf rückgestautes Kühlmittel behindert wird.

Die Erfindung dient vornehmlich zur indirekten oder direkten Kühlung von wärmeabgebenden Komponenten in Einhausungen, insbesondere von einem oder mehreren Servern (insbesondere in Ansammlungen von Servern), sodass manche Komponenten davon durch ein entsprechendes KM2 gekühlt werden und andere Komponenten (insbesondere solche, die eine höhere Temperaturwiderstandsfähigkeit besitzen) durch das gekühlte G1 gekühlt werden, wobei das G1 durch diese Trennung der Kühlungen mit einer höheren Eintrittstemperatur als bisher notwendig verwendet werden kann, insbesondere um eine höhere Ein- und Austrittstemperatur von KM1 zu erreichen.

In einer weiteren Variante dient zur indirekten oder direkten Kühlung von wärmeabgebenden Objekten in Einhausungen, insbesondere von einem oder mehreren Servern (insbesondere in Ansammlungen von Servern, sodass manche Komponenten durch ein entsprechendes KM2 gekühlt werden und andere Komponenten durch die gekühlte Luft gekühlt werden, wobei die Luft, durch diese Trennung der Kühlungen, mit einer höheren Eintrittstemperatur als bisher üblich oder einer bisher üblichen Eintrittstemperatur verwendet werden kann, insbesondere um eine höhere Austrittstemperatur von KM1 zu erreichen.

Eine weitere Variante dient zur indirekten oder direkten Kühlung von wärmeabgebenden Objekten in Einhausungen, insbesondere von einem oder mehreren Servern (insbesondere in Ansammlungen von Servern), sodass manche Komponenten durch ein entsprechendes KM2 gekühlt werden und andere Komponenten durch die gekühlte Luft gekühlt werden, wobei die Luft bei dieser Trennung mit einer höheren Eintrittstemperatur als bisher üblich oder einer bisher üblichen Eintrittstemperatur verwendet werden kann, insbesondere um durch eine hohe Temperaturdifferenz zwischen der Kondensationstemperatur von KM 2 und bisher üblich kaltem KM1 eine besonders hohe Wärmeübertragungsleistung der Kühlung zu erreichen und damit eine besonders hohe Kühlleistung pro Halbleiterelement bzw. pro Komponente A1 zu erreichen oder das Volumen der Komponenten A1 zu senken.

Die beschriebenen Lösungen bieten durch Ihre Art der Kühlung neue Möglichkeiten, insbesondere zur Erhöhung der Wärmestromdichte selektiv dort wo es nötig werden kann oder zur Miniaturisierung von wärmeabgebenden Objekten. Bei anderen wärmeabgebenden Objekten ermöglicht die Erfindung eine selektive Erhöhung der Kühltemperatur, um Kosten zu sparen oder die in KM1 aufgenommene Energie bei einem höheren Temperaturniveau leichter an die Umgebung abgeben zu können oder weiter nutzen zu können, insbesondere zu Heiz- und/oder Trocknungszwecken und/oder zur Erwärmung von thermisch betriebenen Kältemaschinen.

Abweichend davon kann das KM2 bei der Rückkehr von den zu kühlenden Objekten zum Wärmeübertrager eine Flüssig- und/oder Gasphase enthalten, wobei Teilmengen davon auf dem Weg kondensieren können. Die Flüssigphase sammelt sich dabei schwerkraftbedingt unten im Sammler. Die Flüssigphase kann durch folgende Mechanismen vom Sammler in die Flüssigkeitsleitung oder in den WÜ2 transportiert werden, ohne eine motorbetriebene geregelte Pumpe zu verwenden:

Abführen durch Kapillarwirkung mit einem entsprechenden Geflecht, Verdampfen mit thermischer Energie, oder mithilfe einer Blasen- oder Venturipumpe. Es kann vorgesehen sein, eine Flüssigkeitssäule bilden zu lassen, die ein (Schwimmer-)ventil betätigt und die Flüssigkeit in die Flüssigkeitsleitung ablaufen lässt.

Es kann vorgesehen sein, dass Flüssigkeitsanteile des erwärmten und teils verdampften KM2 durch eine Sammlerleitung in der das Gas mitgetragen und (durch Verengung der Leitung) so beschleunigt werden, dass es die Flüssigkeit auch entgegen der Schwerkraft mitreißt.

Es kann ein direktes Einströmen des erwärmten KM2 in den WÜ2 vorgesehen sein, der KM2 mit KM1 kühlt, sodass kein Sammler benötigt wird und die flüssigen Anteile nicht entgegen der Schwerkraft transportiert werden müssen. Insbesondere kann das durch einen Rohrbündel- oder einen Rohrschlangenwärmeübertrager oder einen Rohr- und Lamellen-Wärmeübertrager realisiert werden, oder auch durch einen Plattenwärmeübertrager, bei dem der Zustrom von KM2 auf die Plattengänge verteilt wird.

Computer, Server und IT-Equipment werden heutzutage immer kleiner gebaut. Die erzeugte Wärme in den CPUs/GPUs wird aber nicht in gleichem Maße verringert, sondern sogar teilweise erhöht. Ein enormes Kosteneinsparpotential auf Seiten der Rechenzentrumsbetreiber besteht in der Möglichkeit der Übertaktung der Server. Bei dieser Betriebsweise kann die Rechenleistung der Server erhöht werden, sodass weniger Server betrieben werden müssen, wodurch aber auch die Wärmelast pro CPU/GPU weiter steigt. Daher müssen die Kühllösungen immer höhere Lasten pro Fläche abführen und gleichzeitig auch kompakt sein. Mit aktiver Luftkühlung können keine ausreichenden Wärmeübergangszahlen erreicht werden, wie mit einer Wasser-Flüssigkeitskühlung oder mit einer Kältemittel-Verdampfungskühlung. Außerdem benötigen die Luft-Wärmeübertrager hohe Wärmeübertragungsflächen und zusätzliche Lüfter, was den Platzbedarf, die elektrische Leistungsaufnahme und die Geräuschentwicklung erhöht. Bei einer Kühlung mit einer leitenden Flüssigkeit wie Wasser besteht die Gefahr, dass Leckagen zu schweren Schäden in Servern führen könnten, weshalb viele Anwender eine solche Kühlung nicht bevorzugen. Daher ist es sinnvoll, die Kühlung mit einem dielektrischen Fluid zu betreiben. Die Luftkühlung benötigt neben hohen Luftgeschwindigkeiten durch Lüfter vorbei an großen wärmeübertragenden Oberflächen auch große Temperaturdifferenzen, um die Wärme abzuführen. Diese Temperaturdifferenz kann durch eine Kältemittelkühlung verringert werden, weil der Wärmeübertragungskoeffizient so viel größer ist. Weitere Komponenten in Servern und Serverschränken müssen aber weiterhin mit Luft gekühlt werden, weil eine Kühlung mit Kältemittel zu aufwändig wäre und die Wärmelasten pro Fläche nicht so groß sind. Allerdings können diese Komponenten auch mit wärmerer Luft (z.B. 40-50°C) gekühlt werden oder dafür ausgelegt werden, als die für die CPU/GPU-Luftkühlung üblicherweise benötigten ca. 24 bis 28°C.

Somit kann das gesamte Temperaturniveau der Kühlung stark angehoben werden. Die Wärme aus dem dielektrischen Kältemittel 2 (KM2) und auch die Wärme aus der Luft kann dann auf einem viel höheren Temperaturniveau abgeführt werden. Dies geschieht in Luft-Wasser-Serverschrankklimatisierungsgeräten oder Luft-Kältemittel-Serverschrankklimatisierungsgeräten, die mit dem Kühlwasser oder Kältemittel (allgemein KM2) auch das dielektrische Kältemittel (KM1) kondensieren bzw. kühlen, das die CPUs/GPUs kühlt. Sämtliche Wärmeenergie wird dann im Gerät dem KM1 auf einem sehr hohen Temperaturniveau zugeführt, sodass beispielsweise Kühlwassertemperaturen mit einer Vorlauftemperatur von 38°C und einer Rücklauftemperatur von 45°C erreicht werden (etwa anstelle von z.B. Vorlauf 18°C und Rücklauf 25°C). Auf diesem Temperaturniveau kann die Wärme selbst im Sommer in vielen Ländern an die Umgebung abgeführt werden und im Winter auch zum Heizen von Gebäuden oder Bädern o.ä. dienen. Die Anschaffung einer Kältemaschine kann sich somit bei vielen Anwendungen erübrigen.

Ein direkter Transfer der Wärme durch das KM2 an die Umgebungsluft kann ebenfalls vorgesehen sein. Allerdings müssten hierfür besondere Leitungen verlegt werden, da z.B. die dielektrischen Kältemittel 1,1,1,2,2,4,5,5,5-Nonafluoro-4-(Trifluoromethyl)-3-pentanon oder 1,1,1,2,2,3,3-Heptafluoro-3-methoxypropan relativ zu anderen Kältemitteln kleine Dampfdichten besitzen und sich die Verdampfungstemperatur relativ zu anderen Kältemitteln sehr drucksensitiv verhält. Wasser oder ein anderes Kältemittel mit höherer Dampfdichte und geringerer Drucksensitivität der Verdampfungstemperatur sind für den Transport der Wärme über eine längere Strecke daher besser geeignet. Durch die Anhebung des Temperaturniveaus auch in der zugeführten Luft, kann auch die Wärme aus der Kühlluft auf diesem hohen Temperaturniveau an das KM1 übertragen werden. Da nun weder KM2 noch die Kühlluft auf weniger als 40-50°C gekühlt werden müssen, wird eine Kältemaschine häufig nicht benötigt. Dadurch, dass diese heiße Luft im Schrank verbleibt, sind die Arbeitsbedingungen im Rechenzentrum angenehmer für die Mitarbeiter.

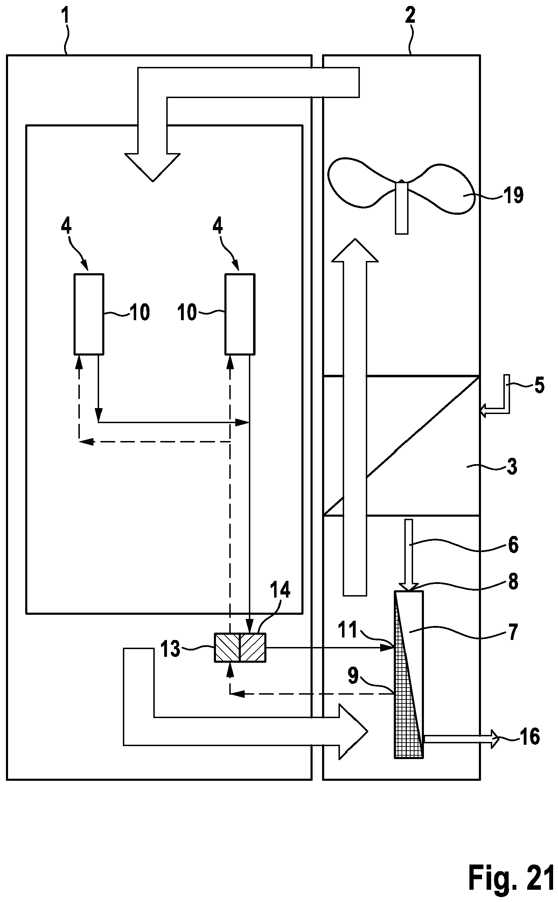

Die Figur 21 veranschaulicht die Fluidführung der Ausführungsform gemäß Figur 3. Demgemäß ist ein geschlossenes Luftleitsystem beschrieben, bei dem die Luft ausschließlich zwischen dem Schaltschrankgehäuse 1 und dem Kühlgerät 2 zirkuliert wird. Insbesondere ist keine Luftzufuhr von außerhalb der Schaltschrankanordnung vorgesehen. Demgegenüber wird über einen Vorlauf 5 gekühlte Flüssigkeit, beispielsweise über einen Chiller bereitgestelltes gekühltes Wasser, der Anordnung von außerhalb zugeführt. Über einen Rücklauf 16 wird die erwärmte Flüssigkeit dem Rückkühler, beispielsweise dem genannten Chiller, wieder zugeführt.

Die über den Luft-Flüssigkeit-Wärmeübertrager 3 zur Verfügung gestellte gekühlte Luft wird in ihrer Strömungsrichtung nach dem Verlassen des Luft-Flüssigkeit-Wärmeübertragers 3 zunächst den Komponenten 4 zugeführt, welche beispielsweise die Komponenten einer Server-Anordnung sein können. Die Luft beaufschlagt die Serverkomponenten 4, wobei eine Wärmeübertragung von den Komponenten 4 auf die Luft erfolgt, mithin die Luft erwärmt wird. Nachdem die Luft die Komponenten 4 passiert hat, wird sie wieder dem Luft-Kältemittel-Wärmetauscher 3 für die Rückkühlung zugeführt.

Die über den Vorlauf 5 bereitgestellte und gekühlte Flüssigkeit wird über die den Luft-Flüssigkeit-Wärmeübertrager 3 durchsetzende Luft erwärmt und über einen Rücklauf 6 des Wärmeübertragers 3 aus dem Wärmeübertrager 3 als erwärmte Flüssigkeit in einen Vorlauf 8 eines Flüssigkeit-Flüssigkeit-Wärmeübertrager 7 eingeleitet. Über den Flüssigkeit-Flüssigkeit-Wärmeübertrager 7 wird ein Kältemittelkreislauf rückgekühlt, über welchen ein zumindest anteilig flüssiges Kältemittel besonders kühlbedürftigen Komponenten 4, mithin Komponenten, die eine hohe Wärmestromdichte aufweisen, zugeführt. Diese Komponenten 4 können beispielsweise CPUs sein. Für die Kühlung der Komponenten kann es ausreichend sein, dass die in diesem Kältemittelkreislauf geführte Flüssigkeit eine Temperatur aufweist, die wesentlich höher als die in dem Schaltschrankgehäuse 1 zirkulierte Luft ist. Beispielsweise kann die Flüssigkeit eine Temperatur von ca. 50 °C aufweisen. Da die Rücklauftemperatur des Luft-Flüssigkeit-Wärmetauschers beispielsweise 35 °C sein kann, ist diese bereits teilerwärmte Flüssigkeit immer noch ausreichend kühl, um eine Rückkühlung der Flüssigkeit für die Komponentendirektkühlung zur Verfügung zu stellen.

Demgemäß wird die über den Vorlauf 8 in den Wärmeübertrager 7 aus dem Wärmeübertrager 3 eingeleitete Flüssigkeit bei dem Passieren des Wärmeübertragers 7 weiter erwärmt und kann beispielsweise auf 50 °C erwärmt werden, mit welcher Temperatur die Flüssigkeit dann über den Rücklauf 16 die Anordnung 1 wieder verlässt, um beispielsweise einem Schiller für die erneute Rückkühlung und Einspeisung in den Vorlauf 5 zugeführt zu werden.

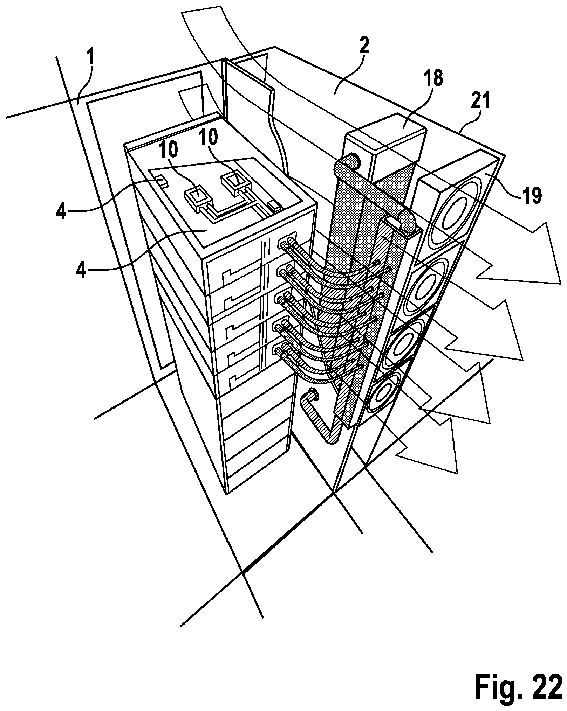

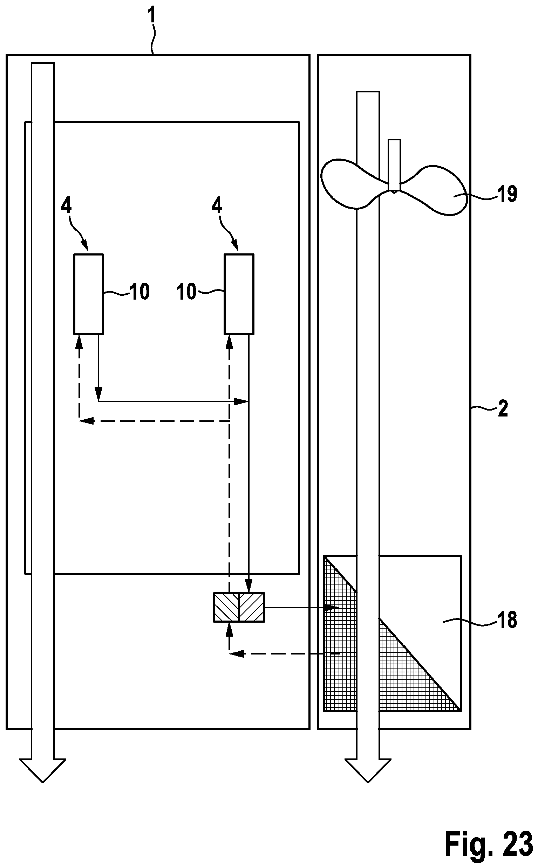

Abweichend von der Ausführungsform gemäß den Figuren 3 und 21 ist in den Figuren 22 und 23 eine Ausführungsform gezeigt, bei welcher die Luft in der Anordnung nicht zirkuliert wird, sondern von einer Rückseite der Anordnung durch die Anordnung hindurch geführt und an einer Vorderseite der Anordnung die Anordnung wieder verlässt. Dabei wird der über die Rückseite in die Anordnung eintretende Luftstrom in einen ersten Teilstrom und einen zweiten Teilstrom zerlegt, wobei der erste Teilstrom das Kühlgerät 2 und der zweite Teilstrom die Schaltschrankanordnung und insbesondere die darin aufgenommenen Komponenten 4, die keiner Flüssigkeitskühlung bedürfen, beaufschlagt, um diese zu kühlen.

In dem Kühlgerät 2 ist ein weiterer Luft-Flüssigkeit-Wärmeübertrager 18 angeordnet, welcher von der das des Kühlgeräts 2 durchsetzenden Luft beaufschlagt wird. Lüfter 19 können dazu vorgesehen sein, die Luft mit einer einstellbaren Strömungsgeschwindigkeit durch den Wärmeübertrager 18 zu treiben. Der Flüssigkeitskreislauf, an welchen der Flüssigkeit-Luft-Wärmeübertrager 18 angeschlossen ist, ist für die direkte Komponentenflüssigkeitskühlung ausgebildet, wie dies grundsätzlich bereits mit Bezug auf die vorangegangen Ausführungsform beschrieben wird.

Abweichend von den zuvor beschriebenen Ausführungsformen ist kein Luft-Flüssigkeit-Wärmeübertrager zur Kühlung der Luft, mit welcher beispielsweise der weitere Luft-Flüssigkeit-Wärmeübertrage 18 und die Komponenten 4 beaufschlagt werden, unmittelbar in dem Kühlgerät 2 oder dem Schaltschrankgehäuse 1 vorgesehen. Vielmehr kann dieser außerhalb der Anordnung, beispielsweise in einem Doppelboden eines Rechenzentrums, in welchem die Schaltschrankanordnung aufgestellt ist, untergebracht sein.

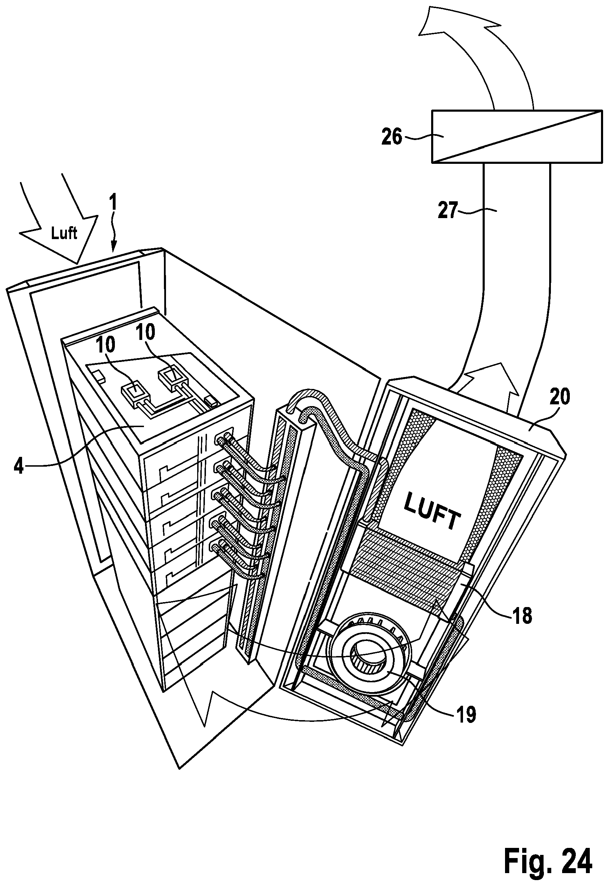

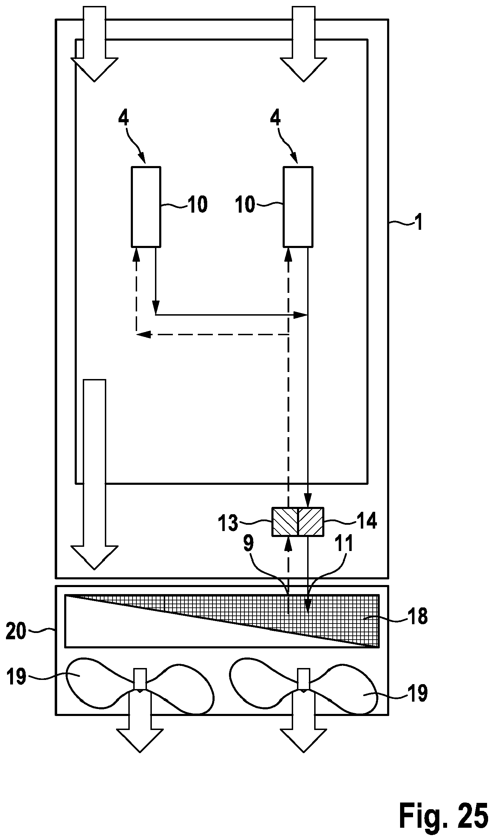

Eine weitere Ausführungsform ist in den Figuren 24 und 25 gezeigt. Bei diesem ist wiederum vorgesehen, dass durch das Schaltschrankgehäuse 1 Luft zur Kühlung von in dem IT-Rack oder dem Schaltschrankgehäuse 1 aufgenommenen Komponenten 4 hindurchgeleitet wird. Von der durch das Gehäuse geleiteten Luft wird nunmehr weiterhin ein Luft-Flüssigkeit-Wärmeübertrager 18 beaufschlagt, wobei eine durch den Luft-Flüssigkeit-Wärmeübertrager 18 geleitete Flüssigkeit mindestens einer der Komponenten 4 für die Wärmeübertragung von der Komponente 4 auf die Flüssigkeit zugeleitet und von der Komponente 4 zurück in den Luft-Flüssigkeit-Wärmeübertrager 18 abgeleitet wird.

Die Luft wird somit wiederum von außerhalb der Schaltschrankanordnung in das Schaltschrankgehäuse 1, beispielsweise über eine Rückseite dieses, eingeleitet. Wiederum passiert die Luft zunächst die Komponenten 4, wobei insbesondere diejenigen Komponenten, welche keine übermäßig hohe Wärmestromdichte aufweisen, bereits eine ausreichende Kühlung erfahren können. Die sich dabei erwärmende Luft passiert nach dem Verlassen der Komponenten 4, beispielsweise nach dem Verlassen eines Servergehäuses, in welchem die Komponenten 4 aufgenommen sind, einen Flüssigkeit-Luft-Wärmeübertrager 18, der nunmehr in einer Tür 20 des Schaltschrankgehäuses 1 aufgenommen ist. In der doppelwandig ausgeführten Tür 20 ist weiterhin ein Lüfter 19 angeordnet, welcher die Luft über die Rückseite des Gehäuses 1 in das Gehäuse 1 einzieht, sodass die Luft die Komponenten 4 passiert, woraufhin die Luft in die Tür 20 eintritt und den Wärmeübertrager 18 durchsetzt. Der Wärmeübertrager 18 weist stromabwärts einen fluiden Übergang zu einem Durchlass durch eine Vorderseite der Schaltschranktür auf, über welche die weiter erwärmte Luft das Schaltschrankgehäuse 1 bzw. die Tür 20 verlassen kann. Der Durchlass kann alternativ auch beispielsweise an der Oberseite der Tür 20 ausgebildet sein.

Wahlweise jedoch nicht zwingend kann vorgesehen sein, dass die erwärmte Luft über einen Schornstein 27 einem weiteren Luft-Flüssigkeit-Wärmeübertrager 26 für die Rückkühlung zugeführt wird. Die das Gehäuse 2 verlassende Luft kann beispielsweise eine Temperatur von 50 °C aufweisen, da sie, wie bereits mit Bezug auf die zuvor beschriebenen Ausführungsformen dargelegt wurde, aufgrund des höheren Temperaturniveaus, welches die für die Flüssigkeitdirektkühlung der Komponenten 4 verwendete Flüssigkeit aufweist, entsprechend weit erhitzt wird.

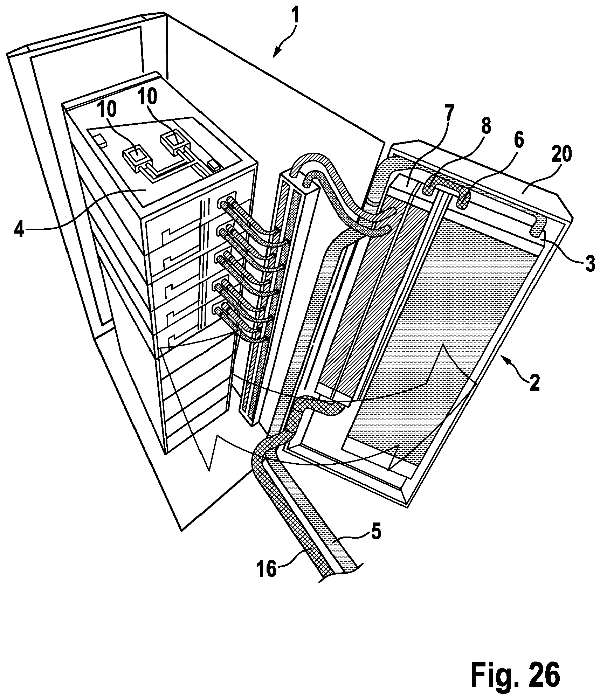

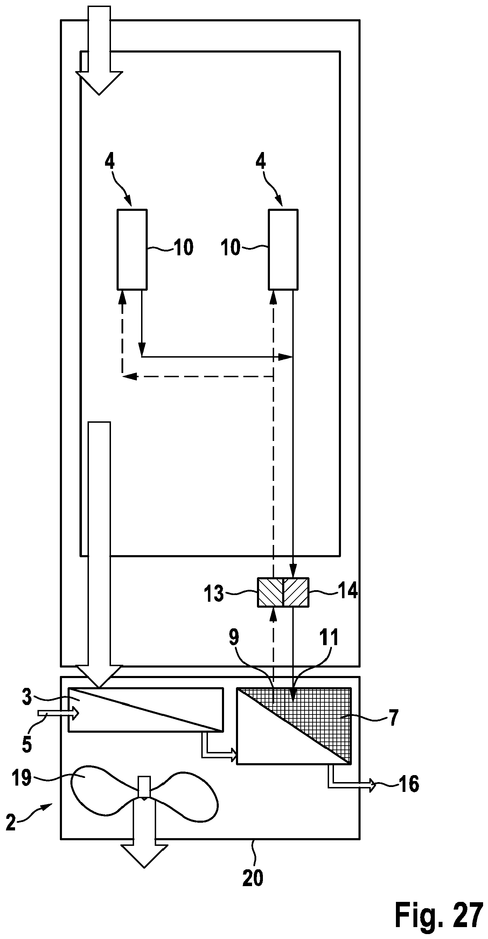

Die Figuren 26 und 27 beschreiben einer Ausführungsform, welche analog zu der Ausführungsform gemäß den Figuren 3 und 21 ausgebildet ist, wobei nunmehr das Kühlgerät 2 anstelle eines Beistellgehäuses in der Tür 20 angeordnet ist. Insbesondere sind der Flüssigkeit-Luft-Wärmetauscher 3 und der mit diesem fluidisch verbundene Flüssigkeit-Flüssigkeit-Wärmetauscher 7 beide in der Tür 20 angeordnet. Weiterhin abweichend von der Ausführungsform gemäß den Figuren 3 und 21 ist bei dieser Ausführungsform analog zu der Ausführungsform gemäß den Figuren 24 und 25 vorgesehen, dass die Luft nicht in einem geschlossenen System zirkuliert wird, sondern über die Rückseite der Schaltschrankanordnung in das Schaltschrankgehäuse 1 eintritt und über die Vorderseite des Schaltschrankgehäuses, insbesondere über die Tür 20, aus dem Schaltschrankgehäuse 1 wieder austritt.

Der weitere Flüssigkeit-Luft-Wärmetauscher 26 kann beispielsweise als ein Wärmeübertrager ausgebildet sein, der in einer Rechenzentrumswand angeordnet ist und beispielsweise den Raum eines Rechenzentrums von der Umgebung des Rechenzentrums oder von einem weiteren Raum, in welchem ein Warmgang oder ein Heißgang des Rechenzentrumsklimatisierungssystems bereitgestellt ist, abtrennt.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Schaltschrankgehäuse
- 2: Kühlgerät
- 3: Luft-Flüssigkeit-Wärmeübertrager
- 4: Komponente
- 5: erster Vorlauf
- 6: erster Rücklauf
- 7: Flüssigkeit-Flüssigkeit-Wärmeübertrager
- 8: zweiter Vorlauf
- 9: dritter Rücklauf
- 10: Wärmeleitkörper
- 11: dritter Vorlauf
- 12: Wärmerohr
- 13: Fallrohr
- 14: Steigrohr
- 15: Rückkühler
- 16: zweiter Rücklauf
- 17: Warmlufteinlass
- 18: zweiter Luft-Flüssigkeit-Wärmeübertrager
- 19: Lüfter
- 20: Rück- oder der Vordertür
- 21: Kühlgerätegehäuse
- 22: Gehäuse
- 23: Außenwand
- 24: Innenwand
- 25: Ringspalt
- 26: weiterer Wärmeübertrager
- 27: Schornstein

## Patentansprüche

1. Schaltschrankanordnung mit mindestens einem IT-Rack oder Schaltschrankgehäuse (1), durch das Luft zur Kühlung von in dem IT-Rack oder Schaltschrankgehäuse (1) aufgenommenen Komponenten (4) hindurchgeleitet ist, wobei von der Luft ein Luft-Flüssigkeit-Wärmeübertrager (18) eines Kühlkreislaufes beaufschlagt und eine durch den Luft-Flüssigkeit-Wärmeübertrager (18) geleitete Flüssigkeit mindestens einer der Komponenten (4) für die Wärmeübertragung von der Komponente (4) auf die Flüssigkeit zugeleitet und von der Komponente (4) zurück in den Luft-Flüssigkeit-Wärmeübertrager (18) abgeleitet ist.

2. Schaltschrankanordnung nach Anspruch 1, bei der die Luft von außerhalb der Schaltschrankanordnung teilweise in das mindestens eine IT-Rack oder das Schaltschrankgehäuse (1) und teilweise in ein dem IT-Rack oder dem Schaltschrankgehäuse (1) beigeordnetes und davon fluidisch getrenntes Kühlgerätegehäuse (21), in welchem der Luft-Flüssigkeit-Wärmeübertrager (18) aufgenommen ist, eingeleitet ist.

3. Schaltschrankanordnung nach Anspruch 1 oder 2, bei der die Luft von außerhalb der Schaltschrankanordnung in das mindestens eine IT-Rack oder das Schaltschrankgehäuse (1) eingeleitet ist, wobei die Schaltschrankanordnung eine Luftführung aufweist, bei der die Luft in ihrer Strömungsrichtung nach dem Eintritt in das IT-Rack oder das Schaltschrankgehäuse (1) die Komponenten beaufschlagt, bevor sie als durch die Komponenten teilweise erwärmte Luft den Luft-Flüssigkeit-Wärmeübertrager (18) beaufschlagt.

4. Schaltschrankanordnung nach Anspruch 2 oder 3, bei der der Luft-Flüssigkeit-Wärmeübertrager (18) des Kreislaufs in einer Rück- oder Vordertür (20) des IT-Racks oder des Schaltschrankgehäuses (1) angeordnet ist, wobei der Luft-Flüssigkeit-Wärmeübertrager (18) von Luft durchströmt ist, die an einer der Rücktür oder der Vordertür gegenüber angeordneten Seite in das IT-Rack oder das Schaltschrankgehäuse (1) eintritt.

5. Schaltschrankanordnung nach Anspruch 4, bei dem das IT-Rack oder das Schaltschrankgehäuse (1) eine Luftführung aufweist, bei der die Luft in ihrer Strömungsrichtung nach dem Eintritt in das IT-Rack oder das Schaltschrankgehäuse (1) die Komponenten beaufschlagt, bevor sie als durch die Komponenten (4) teilweise erwärmte Luft in die Rücktür oder die Vordertür eintritt und den Luft-Flüssigkeit-Wärmeübertrager (18) des Kreislaufes beaufschlagt.

6. Verfahren für die Klimatisierung einer Schaltschrankanordnung, das die Schritte aufweist:
- Beaufschlagen von in einem IT-Rack oder einen Schaltschrankgehäuse (1) der Schaltschrankanordnung aufgenommenen Komponenten (4) mit Luft, wobei die Luft auf eine erste Temperatur erwärmt wird,
- Hindurchleiten der auf die erste Temperatur erwärmten Luft durch einen Luft-Flüssigkeit-Wärmeübertrager (18), wobei eine Flüssigkeit einer Flüssigkeitskühlung der Komponenten (4) abgekühlt und die Luft auf eine zweite Temperatur erwärmt wird, die größer als die erste Temperatur ist.

7. Verfahren nach Anspruch 6, bei dem die Luft nach dem Hindurchleiten durch den Luft-Flüssigkeit-Wärmeübertrager (18) mit der zweiten Temperatur in die Umgebung der Schaltschrankanordnung abgeleitet oder durch einen weiteren Wärmeübertrager (26) abgekühlt und für das erneute Beaufschlagen der Komponenten (4) mit Luft rezirkuliert wird.
